(19) Europäisches Patentamt
European Patent Office
Office européen des brevets

(11) Publication number: 0 300 713 B1

(12) EUROPEAN PATENT SPECIFICATION

(45) Date of publication of patent specification: 30.12.92

(51) Int. Cl.5: **G11B 5/127**, G11B 5/245, H03K 17/92, H03F 19/00

(21) Application number: 88306548.4

(22) Date of filing: 18.07.88

(54) Magnetic circuit.

(30) Priority: 20.07.87 JP 178893/87

(43) Date of publication of application:
25.01.89 Bulletin 89/04

(45) Publication of the grant of the patent:
30.12.92 Bulletin 92/53

(84) Designated Contracting States:
DE FR GB

(56) References cited:
DE-A- 1 564 679
US-A- 3 091 702
US-A- 3 094 628
US-A- 3 310 767

(73) Proprietor: HITACHI, LTD.
6, Kanda Surugadai 4-chome
Chiyoda-ku, Tokyo 100(JP)

(72) Inventor: Kiguchi, Masashi
Hitachi Shoburyo 18-30, Midoricho-5-chome
Koganei-shi(JP)
Inventor: Sukeda, Hirofumi Hitachi Daini
Kyoshinryo
1-3, Higashikoigakubo-3-chome
Kokubunji-shi(JP)
Inventor: Nakao, Takeshi
Haitsu Asahi 102 2327, Kamitsuruma
Sagamihara-shi(JP)
Inventor: Saito, Makoto
2196-430, Hirai Hinodemachi
Nishitama-gun Tokyo(JP)

(74) Representative: Calderbank, Thomas Roger et
al
MEWBURN ELLIS & CO. 2/3 Cursitor Street
London EC4A 1BO(GB)

EP 0 300 713 B1

# Description

This invention relates to a magnetic circuit.

One known magnetic circuit is described in an article entitled "Theoretical Electromagnetics" Second Edition, pp. 161-167, written by Shigenobu Sunagawa and published by Kinokuniya Shoten Ltd. on September 30, 1973.

The magnetic circuit disclosed on that article comprises a magnetc source such as a coil, a magnetic guide guiding a magnetic flux generated from the magnetic source and a gap corresponding to a load. This prior art magnetic circuit may be applied to a magnetic device such as an electromagnet or a magnetic head and, in the prior art magnetic circuit, current supplied to the coil has been modulated for modulating the magnetic field.

Thus, in such a magnetic circuit, the magnetic field has been modulated by a modulating current supplied to the coil forming the magnetic source. However, because the coil forming the magnetic source of the magnetic circuit generally has a large inductance, and an alternating current is supplied to the coil to generate the magnetic flux, such a known magnetic circuit is not capable of high speed modulation of the magnetic field.

Also, because no external modulator for externally modulating the magnetic field is provided, it has been difficult to provide a magnetic circuit which operates in a manner similar to an electrical circuit in which a single power source or oscillator selectively drives a plurality of loads according to their intended service requirements. It is thus not wholly suitable for use as a magnetic head.

US-A-3091702 discloses a magnetic control device comprising a magnetic source, a magnetic circuit having branch paths, each path having a superconductive material part for controlling the magnnetic flux in the branch path, and means for controlling the state of the superconductive material so as to change the magnetic flux from one branch path to another.

The control device of US-A-3091702 is concerned primarily with a magnetic flux gate which is reflected in the preamble of claim 1. The present invention, on the otherhand, is concerned with a magnetic head.

According to the present invention there is provided a magnetic circuit according to claim 1, resulting in a magnetic head.

A superconductor showing perfect diamagnetism has an infinetely large magnetoresistance and acts as means for shielding flow of a magnetic flux. The magnetoresistance of the superconductor decreases when the superconductor is released from its superconducting state by application of external stimulation such as heat, light, an electric current or a strong magnetic field to the superconductor. When such a superconductor whose magnetoresistance can be modulated by external stimulation is incorporated in a magnetic head, a magnetic flux switching operation can be achieved. The period of time required for the phase transition of the superconductor is very short. Therefore, the modulation frequency can be increased to a level corresponding to the energy gap of conduction electrons, and the desired high speed modulation can be attained.

When, for example, two loops are disposed in parallel to each other in a magnetic head, a quantity of magnetic flux corresponding to the loops' magnetoresistance flows through the respective loops. When there is a superconductor in one of the loops, the magnetic flux does not flow through that loop due to the Meissner effect. Then, when the superconductor in that loop is released from its superconducting state by application of external stimulation, the magnetoresistance of that loop decreases to permit flow of the magnetic flux again. When the magnetoresistance of the other loop is far larger than that of the first loop, almost all the magnetic flux flows through the other loop. Thus, the magnetic head can provide a magnetic flux switching operation.

The external stimulation described above may be light directed toward the superconductor to cause a temperature rise of the superconductor by light excitation or light absorption. Also, the external stimulation may be heat, a magnetic field, an electric current or the like applied directly to the superconductor.

Depending on the configuration of the magnetic head magnetic flux may leak toward and into the ambient space. The problem of the external leakage of the magnetic flux can be solved by shielding part or entirety of the magnetic circuit by a shield made of a superconducting material. In such a case, a superconducting material having a critical temperature higher than or a critical current larger than that of the superconducting material used for the modulation is preferably used to provide the shield so as to prevent undesirable damage to the shield due to the modulation. When the superconductor is to be released from its superconducting state by heat generated as a result of light absorption, a light absorber is preferably coated or deposited on the surface of the superconductor so as to enhance the efficiency of light absorption.

Embodiments of the invention will now be descrined in detail, by way of example, with reference to the accompanying drawings in which:

Figs. 1 and 2 show schematically the structure of an embodiment of the magnetic head according to the present invention;

Fig. 3 shows schematically the structure of another embodiment of a magnetic head according to the present invention;

Fig. 4 shows schematically the structure of yet another embodiment of a magnetic head according to the present invention; and

Fig. 5 shows schematically the structure of yet another embodiment of a magnetic head according to the present invention.

Preferred embodiments of the present invention will now be described in detail with reference to the drawings.

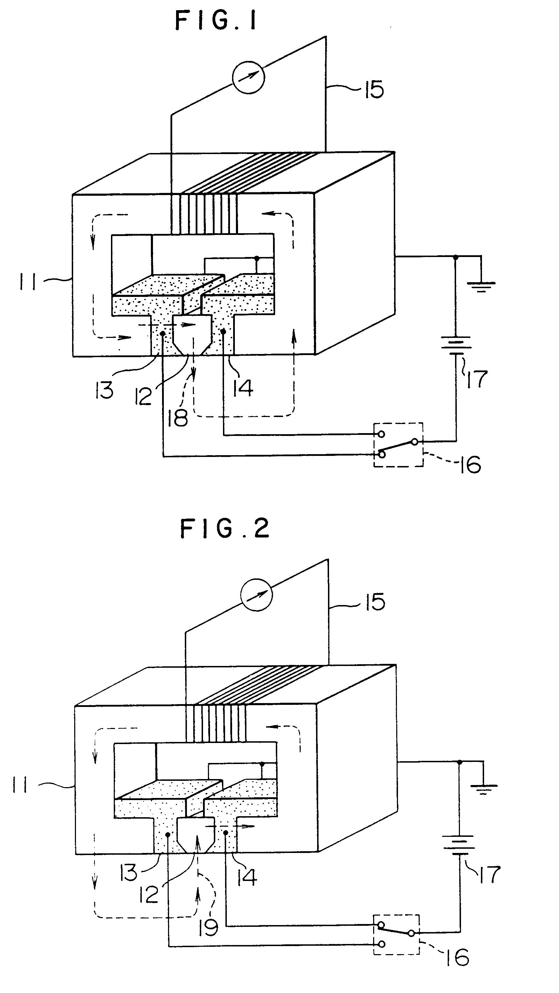

Fig. 1 shows schematically the structure of an embodiment of a magnetic head according to the present invention, being a perpendicular magnetic recording head.

Referring to Fig. 1, the magnetic head includes a magnetic guide 11 and a head end 12 both of which are made of a Mn-Zn ferrite, and a superconductor of Y-Ba-Cu-O composition is buried between the magnetic guide 11 and the head end 12 and sintered to provide a pair of superconducting parts 13 and 14. The gap between the magnetic head and a magnetic coating of a recording medium (not shown) is 1 $\mu$m. A coil 15 is wound around one of the arms of the magnetic guide 11, and a direct current is supplied to the coil 15. A switch 16 is provided to alternately supply a direct current from a power source 17 to the superconducting parts 13 and 14. The superconductor used to form the superconducting parts 13 and 14 has a critical current value of 20 mA, and the value of the direct current supplied from the power source 17 is 40 mA. However, the direct current is not limited to 40 mA and may have any value larger than 20 mA. When the switch 16 is actuated to supply the current to the super conducting part 13, a magnetic flux generated from the coil 15 flows through the superconducting part 13 to reach the head end 12. Since the other superconducting part 14 shows perfect diamagnetism at this time, the magnetic flux flows outward to be applied to the recording medium as a downward magnetic flux 18 as shown by the arrow. Fig. 2 shows that the switch 16 is changed over from the position shown in Fig. 1. Since, in this case, the superconducting part 13 shows perfect diamagnetism, the magnetic flux flows outward to return to the head end 12 and flows then through the superconducting part 14 released from its superconducting state due to the current supply. The magnetic flux flows through such a loop. In Fig. 2, the direction of the magnetic flux at the head end 12 is upward as shown by the arrow, and such an upward magnetic flux 19 is applied to the recording medium. Thus, the direction of the magnetic flux can be controlled by the switch 16 without the necessity for changing over the coil current. In lieu of the mechanical switch 16, a solid-state switching element such as a transistor or an analog switch may be used and integrally combined or integrated together with the magnetic head or a peripheral circuit. The head end 12 has a finely sharpened tip defining a gap of 20 $\mu$m so that the magnetic flux can be concentrated. The lower critical field of the superconductor used in the magnetic head is about 400 G. Therefore, when a magnetic field exceeding this critical value acts upon the superconducting parts 13 and 14, the magnetic flux intrudes into the superconducting parts, resulting in a loss of the magnetic flux. In order to prevent such a loss, the total sectional area of the parts including the superconducting parts 13, 14, the adjoining portions of the magnetic guide 11 and the head end 12 is preferably as wide as possible. In the illustrated magnetic head, this total sectional area is selected to be 2 mm x 1 mm.

Further, when, for example, the direction of the magnetic flux flowing toward the recording medium differs from that shown in Fig. 2, and the magnetic flux may reach from the magnetic guide 11 to the head end 12 while flowing in the other directions, that is, flowing through the upper, front and back sides of the magnetic head, a loss of the magnetic flux also results. In order to prevent such a loss, the upper, front and back surfaces of the magnetic head shown in Figs. 1 and 2 are preferably covered with a superconductor coating.

Electrodes (not shown) of Ag are provided by vacuum deposition on the front and back surfaces of the magnetic head so as to supply the current to the superconducting parts 13 and 14. However, the electrodes may be provided on the upper surface of the magnetic head. The effective spacing cannot be reduced when the electrodes are provided on the lower surface of the magnetic head, that is, the surface directly opposite to the recording medium.

In lieu of the coil 15 employed in the embodiment shown in Figs. 1 and 2, a permanent magnet maybe used when the present invention is applied to a write-only magnetic head. Also, the magnetic head may be a thin film type.

A cryostat cooled by liquid nitrogen may be used for cooling the embodiment of the present invention, or a cold gas may be jetted for the purpose of cooling. Further, the magnetic head may be cooled by a Peltier element.

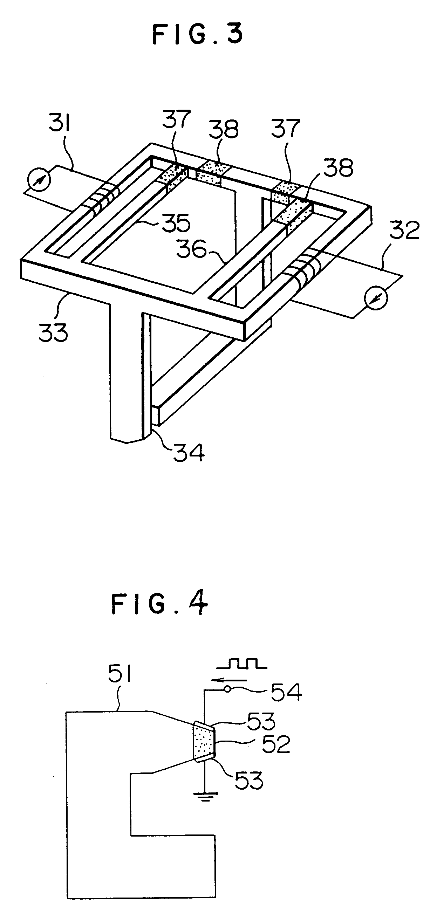

Fig. 3 shows the structure of another embodiment of the present invention when applied also to a horizontal magnetic recording head.

Referring to Fig. 3, a pair of coils 31 and 32 generating magnetic fluxes of directions opposite to each other are wound around respective arms of a magnetic guide 33 of a Mn-Zn ferrite which forms a magnetic circuit together with a pair of bypasses 35 and 36. The magnetic head has a gap 34 of 1 $\mu$m. Superconducting parts 37 and 38 are provided in the magnetic circuit, and current supplied from a power source (not shown) to these superconducting parts 37 and 38 is switched over in a manner similar to that described with reference to Figs. 1 and 2. When the current is supplied to the superconducting parts 37, a magnetic flux generated from the coil 32 flows across the gap 34, while a magnetic flux generated from the coil 31 flows through the bypass 35 and does not reach the gap 34. On the other hand, when the current is supplied to the superconducting parts 38, the magnetic flux generated from the coil 31 flows across the gap 34, while the magnetic flux generated from the coil 32 flows through the bypass 36. Since the coils 31 and 32 generate the magnetic fluxes of the directions opposite to each other, the direction of the magnetic flux flowing across the gap 34 is reversed by changing over the current supply to the superconducting parts 37 and 38. The period of time required for the reversal of the direction of the magnetic flux is shorter than 10 ns, so that high speed modulation of the magnetic flux in the horizontal magnetic recording head can be achieved.

Another embodiment of the present invention will be described with reference to Fig. 4.

Referring to Fig. 4, a portion of a permanent magnet 51 of 200 G is shaped into a sharply tapered form so that the magnetic field can be concentrated, and a superconducting part 52 having electrodes 53 is provided on the tapered end of the permanent magnet 51. When a current larger than the critical current of the superconductor is supplied from a terminal 54 connected to one of the electrodes 53, the density of the magnetic field appearing at the outer end of the superconducting part 52 increases, so that the magnetic field density can be modulated by current.

According to the illustrated embodiment, the space distribution of the flux density of a direct magnetic field generated from, for example, a permanent magnet can be modulated by current. Therefore, the present invention can provide a magnetic head which can operate at a high modulation speed in spite of a simple structure. In the illustrated embodiment, current is used for magnetic modulation.

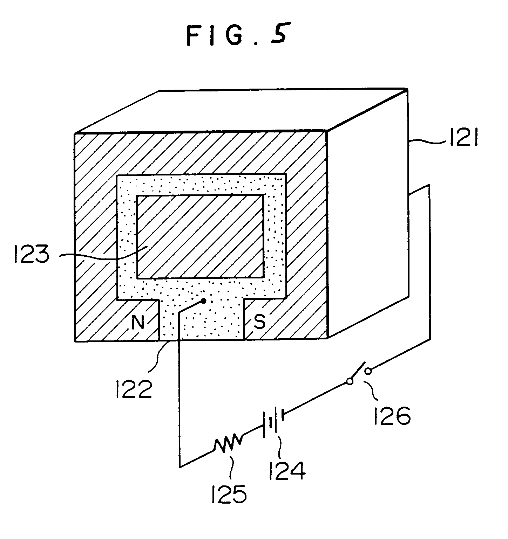

Yet another embodiment of the present invention will be described with reference to Fig. 5.

Referring to Fig. 5, a block 123 of a ferrite is placed in an internal cavity of a permanent magnet 121, and the remaining space is filled with a superconductor 122. A power source 124 is connected through a resistor 125 and a switch 126 to the superconducting part 122 so that current supplied from the power source 124 can be turned on-off by the switch 126. The resistor 125 is provided to protect the power source 124 and has a resistance of 51 Ω. The power supply voltage of the power source 124 is 10 V.

In the off state of the current, a magnetic flux cannot flow through the superconducting part 122 and flows out of the permanent magnet 121. In this case, the permanent magnet 121 operates as an ordinary magnet. On the other hand, in the on state of the current having a value larger than the critical current of the superconductor, the superconducting part 122 is released from its superconducting state, and the magnetic flux flows into the internal ferrite block 123 and does not flow to the outside of the permanent magnet 121. In this case, the permanent magnet 121 does not exhibit its magnetic action. Thus, the magnetic action of the permanent magnet 121 can be controlled by current. Although the permanent magnet is used in the illustrated embodiment, an electromagnet may be used in lieu of the permanent magnet. In such a modification, the magnetic action can be controlled at a higher speed by a current having a smaller value than when a coil current is turned on-off.

Superconductors of oxygen deficiency type perovskite structure expressed by a general formula

$$(RE_{1-x} 2M_{x/2}) CuO_{3-x}$$

or those of $K_2NiF_4$ structure can be used as superconducting materials employed in all of the aforementioned embodiments. In the general formula described above, RE represents one of elements such as La, Y, Sr, Yb, Lu, Tm, Dy, Sc, Ce, Pr, Nd, Sm, Eu, Gd, Tb, Ho and Er, and M represents one of elements such as Ba, Sr, Ca and K.

Further, although all of the aforementioned embodiments have referred to a magnetic circuit of bulk structure, the magnetic circuit may be integrated into the form of a thin-film integrated circuit.

It will be understood from the foregoing detailed description that, according to the magnetic circuit of the present invention, a magnetic flux can be switched over by external stimulation such as a current, light, heat or a magnetic field. Since the switching operation is not affected by an inductance, high speed modulation can be achieved. Also, even when a static magnetic field is applied to a load such as a coil, the magnetic field can be turned into an alternating magnetic field by external modulation, an electromotive force can be produced by the coil. When a superconducting coil storing a magnetic flux is used as a magnetic source, a magnetic flux source corresponding to a current source in an electrical circuit can be provided, and the magnetic circuit can be easily designed because a change in the load does not change the magnetic flux. Further, when a magnetic source generating an alternating magnetic field is used in the magnetic circuit, and another signal is applied for switching the magnetic flux, mixing of the magnetic signal can be attained, so that the magnetic circuit can be applied to communication and logic circuits.

## Claims

1.  A magnetic circuit comprising:

    a closed magnetic path including a magnetic source (15;31;32;51;121) for generating magnetic flux in one direction in said magnetic path;

    superconducting material (13;14;37;38;52;122) incorporated in the magnetic path; and

    means (16;17;53;54;124;125;126) for controlling the phase transition of said superconducting material;

    characterised in that:

    the closed magnetic path includes at least one physical discontinuity (13;14;34;52;122) located in the magnetic path so, in use, to be proximate a magnetic medium acted on by said head whereby to change the magnetic flux through said discontinuity relative to said magnetic medium.

2.  A magnetic circuit according to claim 1, wherein at least one magnetic discontinuity is formed by two regions (13,14) of said superconducting material, the two regions being spaced apart by a predetermined distance (12), and wherein the means for selectively controlling the phase transition being switching means (16).

3.  A magnetic circuit according to claim 1, wherein said magnetic source comprises two means (31,32) for generating magnetic flux, said means for controlling phase transition is selectively operated such that said magnetic flux going through said magnetic discontinuity is from only one of said magnetic flux generating means; the magnetic head further comprises:

    a first magnetic path (31-38-34-33) and a second magnetic path (32-37-34-33) each of which comprises said superconducting material and is independently formed with respect to said magnetic flux generating means;

    a third magnetic path (35) and a fourth magnetic path (36) for independently bypassing magnetic flux going through said first and second magnetic paths with respect to said magnetic flux generating means, each of said third and fourth magnetic paths comprising said superconducting material (37,38) for turning on or off of said third and fourth magnetic paths.

4.  A magnetic circuit according to claim 1, wherein said magnetic source is a permanent magnet (51,121) said closed magnetic path is formed through a magnetic pole and a magnetic medium proximate said magnetic pols, and said superconducitng material (52,122) is disposed at least at one magnetic pole.

5.  A magnetic circuit according to any one of claims 1 to 4, wherein said phase transition controlling means is arranged to be controlled by a current flowing in said superconducting material.

6.  A magnetic circuit according to any one of claims 1 to 4, wherein said phase transition controlling means is arranged to be controlled by a laser light irradiated onto said superconducting material.

7.  A magnetic circuit according to any one of claims 1 to 4 wherein said phase transition controlling means is arranged to be controlled by a magnetic field operated to said superconducting material.

8.  A magnetic circuit according to any one of claims 1 to 4 wherein said phase transition controlling means is arranged to be controlled by heating said superconducting material.

## Patentansprüche

1.  Magnetkreis mit

    einem geschlossenen Magnetweg, der eine Magnetquelle (15; 31; 32; 51; 121) zum Erzeugen eines Magnetflusses in einer Richtung des genannten Magnetweges umfaßt;

    einem supraleitenden Material (13; 14; 37; 38; 52; 122), das im Magnetweg enthalten ist; und

    einer Einrichtung (16; 17; 53; 54; 124; 125; 126) zum Steuern des Phasenübergangs des supraleitenden Materials; dadurch **gekennzeichnet**, daß

    der geschlossene Magnetweg mindestens eine physikalische Diskontinuität (13; 14; 34; 52; 122) aufweist, die im Magnetweg so angeordnet ist, daß sie im Gebrauch einem magnetischen Medium nächstgelegen ist, auf das vom genannten Kopf eingewirkt wird, um hierdurch den Magnetfluß durch die genannte Diskontinuität relativ zum magnetischen Medium zu ändern.

2.  Magnetkreis nach Anspruch 1, worin mindestens eine magnetische Diskontinuität durch zwei Bereiche (13, 14) des supraleitenden Materials gebildet ist, wobei die beiden Bereiche voneinander um einen vorbestimmten Abstand (12) getrennt sind, und worin die Einrichtung zum wahlweisen Steuern des Phasenüberganges eine Schalteinrichtung (16) ist.

3. Magnetkreis nach Anspruch 1, worin die genannte Magentquelle zwei Einrichtung (31, 32) zum Erzeugen eines Magnetflusses aufweist, und die Einrichtung zum Steuern des Phasenüberganges wahlweise so betätigt wird, daß der genannte Magnetfluß, der durch die genannte magnetische Diskontinuität hindurchgeht, nur von einer der genannten magnetflußerzeugenden Einrichtungen stammt; wobei der Magnetkopf ferner folgendes aufweist:
einen ersten Magnetweg (31-38-34-33) und einen zweiten Magnetweg (32-37-34-33), von welchen jeder das genannte supraleitende Material aufweist und unabhängig hinsichtlich der genannten magnetflußerzeugenden Einrichtung ausgebildet ist;
einen dritten Magnetweg (35) und einen vierten Magnetweg (36) zum unabhängigen Umleiten des Magnetflusses, der durch den genannten ersten und zweiten Magnetweg hindurchgeht, hinsichtlich der genannten magnetflußerzeugenden Einrichtung, wobei jeder des genannten dritten und vierten Magnetweges das genannte supraleitende Material (37, 38) aufweist, um den genannten dritten und vierten Magnetweg an- oder abzuschalten.

4. Magnetkreis nach Anspruch 1, worin die genannte Magnetquelle ein Permanentmagnet (51, 121) ist, der genannte geschlossene Magnetweg durch einen Magnetpol hindurch und ein magnetisches Medium, das dem genannten Magnetpol nächstgelegen ist, gebildet ist, und das genannte supraleitende Material (52, 122) mindestens an einem Magnetpol angeordnet ist.

5. Magnetkreis nach irgendeinem der Ansprüche 1 bis 4, worin die genannte, den Phasenübergang steuernde Einrichtung so angeordnet ist, daß sie durch einen Strom zu steuern ist, der im genannten supraleitenden Material fließt.

6. Magnetkreis nach irgendeinem der Ansprüche 1 bis 4, worin die genannte, den Phasenübergang steuernde Einrichtung dazu eingerichtet ist, von einem Laserlicht gesteuert zu werden, das auf das supraleitende Material aufgestrahlt wird.

7. Magnetkreis nach irgendeinem der Ansprüche 1 bis 4, worin die genannte, den Phasenübergang steuernde Einrichtung so angeordnet ist, daß sie von einem Magnetfeld gesteuert wird, das am supraleitenden Material betrieben wird.

8. Magnetkreis nach irgendeinem der Ansprüche 1 bis 4, worin die genannte, den Phasenübergang steuernde Einrichtung so angeordnet ist, daß sie durch Erwärmen des genannten supraleitenden Materials zu steuern ist.

## Revendications

1. Circuit magnétique comprenant :
un trajet magnétique fermé comprenant une source magnétique (15;31;32;51;121) servant à produire un flux magnétique dans une direction dans ledit trajet magnétique;
un matériau supraconducteur (13;14;37;38;52;122) incorporé dans le trajet magnétique; et
des moyens (16;17;53;54;124;125;126) pour commander la transition de phase dudit matériau supraconducteur; caractérisé en ce que le trajet magnétique fermé comprend au moins une discontinuité physique (13;14;34;52;122) située dans le trajet magnétique de manière à être, en cours d'utilisation, proche d'un milieu magnétique sur lequel agit ladite tête de manière à modifier le flux magnétique traversant ladite discontinuité par rapport audit milieu magnétique.

2. Circuit magnétique selon la revendication 1, dans lequel au moins une discontinuité magnétique est formée par deux régions (13,14) dudit matériau supraconducteur, ces deux régions étant séparées par une distance prédéterminée (12), et dans lequel les moyens de commande sélective de la transition de phase sont des moyens de commutation (16).

3. Circuit magnétique selon la revendication 1, dans lequel ladite source magnétique comprend des moyens (31,32) pour produire un flux magnétique, lesdits moyens pour commander la transition de phase étant actionnés de façon sélective de telle sorte que ledit flux magnétique traversant ladite discontinuité magnétique émane uniquement de l'un desdits moyens de production du flux magnétique; la tête magnétique comprenant en outre :
un premier trajet magnétique (31-38-34-33) et un second trajet magnétique (32-37-34-33), dont chacun comprend ledit matériau supplémentaire et est formé de façon indépendante par rapport auxdits moyens de production du flux magnétique;

un troisième trajet du flux magnétique (35) et un quatrième trajet magnétique (36) pour dériver de façon indépendante le flux magnétique traversant lesdits premier et second trajets magnétiques par rapport auxdits moyens de production du flux magnétique, chacun desdits troisième et quatrième trajets magnétiques comprenant ledit matériau supraconducteur (37,38) pour fermer ou ouvrir lesdits troisième et quatrième trajets magnétiques.

4. Circuit magnétique selon la revendication 1, dans lequel ladite source magnétique est un aimant permanent (51,121), ledit trajet magnétique fermé est formé par un pôle magnétique et un milieu magnétique proche dudit pôle magnétique, et ledit matériau supraconducteur (52,122) est disposé au moins sur un pôle magnétique.

5. Circuit magnétique selon l'une quelconque des revendications 1 à 4, dans lequel lesdits moyens de commande de transition de phase sont agencés de manière à être commandés par un courant pénétrant dans ledit matériau supraconducteur.

6. Circuit magnétique selon l'une quelconque des revendications 1 à 4, dans lequel lesdits moyens de commande de transition de phase sont agencés de manière à être commandés par une lumière laser envoyée sur ledit matériau supraconducteur.

7. Circuit magnétique selon l'une quelconque des revendications 1 à 4, dans lequel lesdits moyens de commande de transition de phase sont agencés de manière à être commandés par un champ magnétique appliqué audit matériau supraconducteur.

8. Circuit magnétique selon l'une quelconque des revendications 1 à 4, dans lequel lesdits moyens de commande de transition de phase sont agencés de manière à être commandés au moyen d'un chauffage dudit matériau supraconducteur.

# F I G . I

# F I G . 2

# FIG.3

# FIG.4

# FIG. 5

121

123

N    S

122

125    124    126